# EUROPEAN PATENT APPLICATION

(11) **EP 4 614 564 A1**
(43) Date of publication of application: **10.09.2025**
(21) Application number: 23883892.4
(22) Date of filing: 29.09.2023
(51) Int. Cl.: H01L 23/44, H05K 7/20

(54) **COOLING DEVICE**

(30) Priority: 02.11.2022 JP 2022176525
(71) Applicant: Jatco Ltd., Shizuoka 417-8585 (JP)
(72) Inventor: HAGIMORI, Hisaya, Fuji-shi, Shizuoka 417-8585 (JP); MOCHIDUKI, Yuuma, Fuji-shi, Shizuoka 417-8585 (JP)
(74) Representative: Hoefer & Partner Patentanwälte mbB
(86) International application number: PCT/JP2023/035772
(87) International publication number: WO 2024/095653

(57) **Abstract**

[PROBLEMS] To achieve both simplification of a device and high cooling efficiency of insulating oil having received heat.

[SOLUTIONS] A cooling device cools a power semiconductor device. The cooling device includes a tank that accommodates a power semiconductor device, insulating oil, and a refrigerant liquid having a boiling point temperature lower than a boiling point temperature of the insulating oil and a specific gravity larger than a specific gravity of the insulating oil. The insulating oil and the refrigerant liquid are stored in the tank in a mixed state to cool the power semiconductor device.

## Description

### TECHNICAL FIELD

The present invention relates to a cooling device.

### BACKGROUND ART

Patent Document 1 discloses a cooling device in which a semiconductor stack is immersed in insulating oil to be accommodated in an oil inlet tank, a hydraulic fluid is sealed in a heat pipe type heat dissipater on both sides of a semiconductor device, and cooling is performed using a boiling-condensing cycle of the sealed hydraulic fluid. In this cooling device, the insulating oil and the hydraulic fluid are in a non-mixed state, and the insulating oil heated by the heat dissipater is cooled by natural convection in the oil inlet tank or forced convection to a pump and radiating heat to an atmosphere through a radiator attached to the tank.

### PRIOR ART DOCUMENT

### PATENT DOCUMENT

Patent Document 1: JPH08-97338A

### SUMMARY OF INVENTION

### PROBLEMS TO BE SOLVED BY THE INVENTION

In the case of causing natural convection of the insulating oil having received heat, the cooling device can be simplified as compared with the case of forced convection, but it is difficult to obtain high cooling efficiency as compared with the case of forced convection. On the other hand, in the case where the insulating oil having received heat is forced convection, high cooling efficiency can be obtained as compared with the case of natural convection. As a result of the need to add a device such as a pump for forced convection of the insulating oil, simplification of the cooling device may be hindered.

The present invention has been made in view of such a problem, and an object of the present invention is to achieve both simplification of a device and high cooling efficiency of insulating oil having received heat.

### SOLUTIONS TO THE PROBLEMS

A cooling device according to an aspect of the present invention is a cooling device for cooling a power semiconductor device, the cooling device includes: a tank that accommodates a power semiconductor device; insulating oil; and a refrigerant liquid having a boiling point temperature lower than a boiling point temperature of the insulating oil and a specific gravity larger than a specific gravity of the insulating oil. The insulating oil and the refrigerant liquid are stored in the tank in a mixed state to cool the power semiconductor device.

### ADVANTAGEOUS EFFECTS OF INVENTION

According to this aspect, the insulating oil and the refrigerant liquid stored in the tank in the mixed state are present at different positions in a height direction due to a difference in specific gravity. As a result, the refrigerant liquid having a large specific gravity is positioned below the insulating oil. Therefore, by performing vaporization heat cooling with the refrigerant liquid without particularly adding a device for forced convection, the insulating oil above the vaporized refrigerant liquid can be stirred. Accordingly, the insulating oil having received heat can be forced convection. Accordingly, it is possible to achieve both simplification of a device and high cooling efficiency of insulating oil having received heat.

### BRIEF DESCRIPTION OF DRAWINGS

[FIG. 1] FIG. 1 is a schematic configuration diagram of a cooling device.
[FIG. 2] FIG. 2 is a view showing a state of the cooling device when an electric circuit is operated.
[FIG. 3] FIG. 3 is a diagram showing a first modification of an electric circuit and a cooling device.
[FIG. 4] FIG. 4 is a diagram showing a second modification of an electric circuit and a cooling device.

### DESCRIPTION OF EMBODIMENTS

Hereinafter, an embodiment of the present invention will be described with reference to the accompanying drawings.

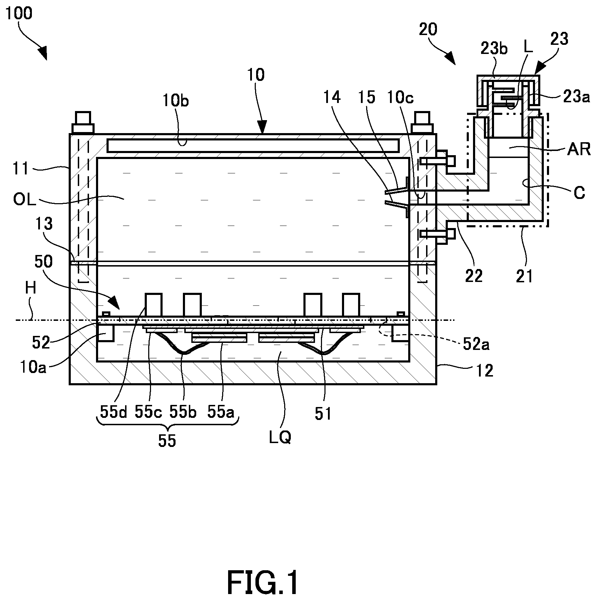

FIG. 1 is a schematic configuration diagram of a cooling device 100. FIG. 1 shows a static state in which an electric circuit 50 is not operated and is in an environmental temperature state. The environmental temperature is an outside air temperature or an atmospheric temperature, for example, at room temperature. An up-down direction in FIG. 1 corresponds to a vertical direction (a height direction).

The cooling device 100 cools the electric circuit 50. The electric circuit 50 is, for example, an inverter (an electric circuit functioning as an inverter), and corresponds to a power semiconductor device. The electric circuit 50 includes a first substrate 51, a second substrate 52, and a circuit portion 55. The first substrate 51 and the second substrate 52 are printed substrates, and the first substrate 51 is laminated on the second substrate 52. The circuit portion 55 is mounted on the first substrate 51 and the second substrate 52, and is electrically connected to the first substrate 51 and the second substrate 52 by being connected to circuit patterns of the first substrate 51 and the second substrate 52.

The circuit portion 55 includes semiconductor devices 55a, a wire 55b, a lead frame 55c, and a capacitor 55d. The semiconductor devices 55a, the wire 55b, and the lead frame 55c are mounted on the first substrate 51, and the capacitor 55d is mounted on the second substrate 52. Each of the semiconductor devices 55a is a power element and is a switching element such as an IGBT or a power MOSFET. A plurality of the semiconductor devices 55a are provided, and in the present embodiment, the semiconductor devices 55a are arranged in two rows along a back and front direction of FIG. 1 (a direction orthogonal to the paper surface of FIG. 1). The arrangement of the plurality of semiconductor devices 55a is not limited thereto.

The semiconductor devices 55a are electrically connected to the lead frame 55c via the wire 55b. The semiconductor devices 55a are sealed by a mold resin, and heat radiation from the semiconductor devices 55a is performed via the mold resin. Heat radiation from the semiconductor devices 55a can also be performed via the lead frame 55c. The semiconductor devices 55a are provided on a lower side (back side) of the second substrate 52 together with the wire 55b and the lead frame 55c, and the capacitor 55d is provided on an upper side (a front side) of the second substrate 52.

The semiconductor devices 55a and the capacitor 55d are examples of a plurality of electronic components included in the electric circuit 50, and the semiconductor devices 55a and the capacitor 55d have different heat generation densities. The electric circuit 50 may include electronic components other than the semiconductor devices 55a and the capacitor 55d. In the present embodiment, the capacitor 55d is an example of an electronic component other than the semiconductor devices 55a among the plurality of electronic components, and represents an electronic component other than the semiconductor devices 55a. The heat generation density of the semiconductor device 55a is relatively higher than that of the capacitor 55d, and the semiconductor device 55a and the capacitor 55d correspond to a plurality of electronic components having different heat generation densities.

The cooling device 100 includes a tank 10 and a sub-tank 20. The tank 10 accommodates the electric circuit 50. A boss 10a is provided on an inner surface of a side wall of the tank 10, and the second substrate 52 is fixed to the boss 10a. The second substrate 52 divides an inside of the tank 10 into an upper space and a lower space. A plurality of through holes 52a are formed in the second substrate 52, and the upper space and the lower space in the tank 10 communicate with each other via the plurality of through holes 52a. The plurality of through holes 52a can be provided, for example, at positions not overlapping the first substrate 51 when viewed in the vertical direction.

The tank 10 includes a first housing portion 11, a second housing portion 12, and a seal member 13. Both the first housing portion 11 and the second housing portion 12 have a box shape with one surface opened. The first housing portion 11 and the second housing portion 12 are coupled to each other by bolt fastening in a state in which mating surfaces of the openings are mated with each other via the seal member 13. The first housing portion 11 is disposed on the second housing portion 12, and the boss 10a is provided on the second housing portion 12.

The insulating oil OL and the refrigerant liquid LQ are stored in the tank 10 in a mixed state. The mixed state is a state in which the insulating oil OL and the refrigerant liquid LQ are mixed in the same space without being isolated from each other, and includes a case where the insulating oil OL and the refrigerant liquid LQ in a static state are separated in accordance with a specific gravity. The insulating oil OL is hydrocarbon-based oil, and for example, the same oil as oil used for cooling and lubrication in a continuously variable transmission mechanism is used. The refrigerant liquid LQ is a fluorine-based refrigerant (fluorine-based inert liquid), and, for example, perfluorocarbon carbon (PFC) is used as the fluorine-based refrigerant LQ. The refrigerant liquid LQ, which is a fluorine-based refrigerant, has a larger specific gravity than the insulating oil OL. Therefore, when the insulating oil OL and the refrigerant liquid LQ are stored in the tank 10 in a mixed state, the insulating oil OL is present on an upper side and the refrigerant liquid LQ is present on a lower side in the tank 10.

A storage amount of the refrigerant liquid LQ stored in the tank 10 is smaller than the capacity of the second housing portion 12. For this reason, the refrigerant liquid LQ in a static state is accumulated at the bottom of the tank 10 in the second housing portion 12. The remaining space other than a space occupied by the refrigerant liquid LQ in the tank 10 is filled with the insulating oil OL. For this reason, the insulating oil OL is present at the coupling position of the first housing portion 11 and the second housing portion 12 in the height direction.

The seal member 13 seals a space between the first housing portion 11 and the second housing portion 12 coupled to each other. The seal member 13 is provided within a range in the height direction in which the insulating oil OL is stored in accordance with the specific gravity, and prevents leakage of the insulating oil OL. The seal member 13 can be formed of, for example, a gasket.

The tank 10 includes a coolant passage 10b and a through hole 10c. The coolant passage 10b is formed inside an upper wall of the tank 10 constituted by the first housing portion 11. The coolant flows through the coolant passage 10b, and the coolant receives heat from the insulating oil OL and the refrigerant liquid LQ in the tank 10 to cool the insulating oil OL and the refrigerant liquid LQ. The through hole 10c passes through the side wall of the tank 10 formed by the first housing portion 11. Accordingly, the through hole 10c is provided within a range in the height direction in which the insulating oil OL is stored in accordance with the specific gravity (within a range in the height direction in which the insulating oil OL is present in a static state). The through hole 10c extends in a horizontal direction and penetrates the side wall of the tank 10.

The tank 10 further includes a shielding plate 14 and a shielding plate 15. The shielding plate 14 and the shielding plate 15 are provided on the inner surface of the side wall of the tank 10 in which the through hole 10c is provided. The shielding plate 14 is provided at a lower portion of the through hole 10c around the opening into the tank 10, and the shielding plate 15 is provided at an upper portion around the opening. The shielding plate 14 extends obliquely upward along an extending direction of the through hole 10c such that the shielding plate 14 is positioned higher as the shielding plate 14 is away from the through hole 10c. The shielding plate 15 extends obliquely downward along the extending direction of the through hole 10c such that the shield plate 15 is positioned lower as the shield plate 15 is away from the through hole 10c. A gap is formed between a tip end portion of the shielding plate 14 and a tip end portion of the shielding plate 15. Therefore, a communication state between the inside of the tank 10 and the through hole 10c is not blocked by the shielding plate 14 and the shielding plate 15.

Each of the shielding plate 14 and the shielding plate 15 has, for example, a deformed L-shaped cross section having an angle larger than a right angle, and can be provided by fixing one plate-shaped portion as a fixed portion to the inner surface of the side wall of the tank 10 with bolts or the like. The shielding plate 14 and the shielding plate 15 can be provided over a range in which the through hole 10c is provided at least in the back and front direction of FIG. 1. Instead of the shielding plate 14 and the shielding plate 15, for example, a tubular member having a tapered shape that tapers as going away from the through hole 10c along the extending direction of the through hole 10c may be provided.

The sub-tank 20 is provided in the tank 10. The sub-tank 20 includes a tank portion 21 and a connection portion 22. The tank portion 21 has a cylindrical shape. The tank portion 21 extends along the vertical direction and opens at an upper end portion. The connection portion 22 has a pipe shape and extends in the horizontal direction. The connection portion 22 has, for example, a flange as a fixed portion at an open end, and the sub-tank 20 is fixed to the tank 10 by fastening the flange to the side wall of the tank 10 by bolts.

The connection portion 22 is connected to a lower portion of the tank portion 21 from a radial direction at a base end portion and opens into the tank portion 21, and is connected to the through hole 10c at the open end. Therefore, the insulating oil OL stored to fill the inside of the tank 10 satisfies a part of an inside of the tank portion 21 to fill the through hole 10c and the connection portion 22. A seal member may be provided between the connection portion 22 and the side wall of the tank 10 to prevent leakage of the insulating oil OL.

The sub-tank 20 further includes an air chamber AR. The air chamber AR is formed immediately above the insulating oil OL in the tank portion 21. The air chamber AR communicate with the inside of the tank portion 21 via a communication passage C. The communication passage C includes the tank portion 21 in a portion filled with the insulating oil OL, the connection portion 22, and the through hole 10c.

The sub-tank 20 further includes a breather cap 23. The breather cap 23 is provided at an upper end portion of the tank portion 21. The breather cap 23 includes a main body 23a and an umbrella portion 23b. The main body 23a has a cylindrical shape, and a screw is formed on an outer periphery of one end portion of the main body 23a. The main body 23a is screwed into a screw formed on an inner periphery of an upper end portion of the tank portion 21. The main body 23a is fastened until a flange portion provided on the outer periphery of the main body 23a comes into contact with the tank portion 21, whereby the breather cap 23 is fixed to the tank portion 21.

The umbrella portion 23b is provided at the other end portion of the main body 23a. The umbrella portion 23b has a bottomed cylindrical shape and covers the main body 23a from above to prevent water from entering from the outside. A gap is formed between the main body 23a and the umbrella portion 23b in the circumferential direction, and the gap opens downward to the outside air. A communication hole communicating the inside and the outside is formed in a peripheral wall of the other end portion of the main body 23a. Accordingly, the breather cap 23 allows the air chamber AR to communicate with the outside air outside the sub-tank 20 through the communication hole and the gap.

A labyrinth flow path L is formed in the main body 23a. The labyrinth flow path L allows air to pass therethrough, while preventing the insulating oil OL from passing therethrough. Each of the wall portions forming the labyrinth flow path L may be provided to urge the insulating oil OL to fall by its own weight by, for example, inclining the wall portions to be positioned downward toward a tip end side. The breather cap 23 corresponds to an air breather mechanism.

In a static state, the refrigerant liquid LQ has a liquid surface height H, and the second substrate 52 is provided such that the liquid surface height H is positioned between an upper surface and a lower surface thereof. Therefore, the semiconductor devices 55a provided on a back side of the second substrate 52 are accommodated while being immersed in the refrigerant liquid LQ at a lower side in the tank 10 (lower than the insulating oil OL), and the capacitor 55d provided on a front side of the second substrate 52 is accommodated while being immersed in the insulating oil OL. As a result, in the cooling device 100, the electric circuit 50 is cooled as follows.

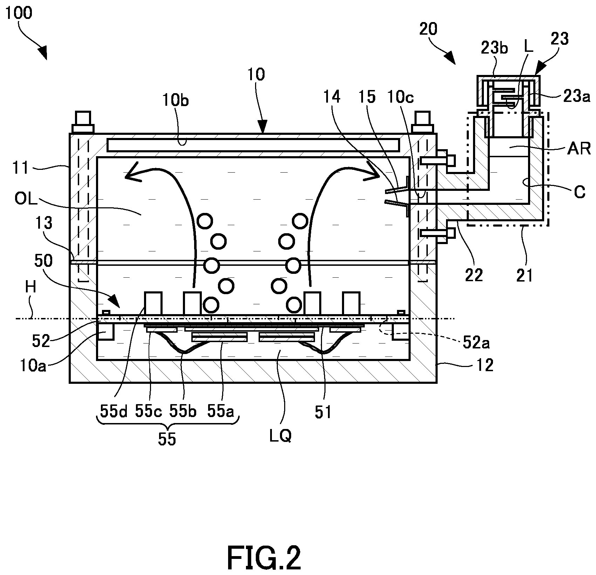

FIG. 2 is a view showing a state of the cooling device 100 when the electric circuit 50 is operated. When the electric circuit 50 is operated, the semiconductor devices 55a and the capacitor 55d generate heat. In the cooling device 100, the electric circuit 50 is cooled by the vaporization heat cooling by the refrigerant liquid LQ and the heat reception by the insulating oil OL. Since the semiconductor devices 55a are immersed in the refrigerant liquid LQ, the refrigerant liquid LQ is vaporized when the semiconductor devices 55a generate heat. Accordingly, the semiconductor device 55a having a relatively higher heat generation density is cooled by vaporization heat cooling, so that the electric circuit 50 is effectively cooled.

The capacitor 55d immersed in the insulating oil OL is cooled by heat radiation to the insulating oil OL. This is because the capacitor 55d having a lower heat generation density than the semiconductor device 55a can be sufficiently cooled by the insulating oil OL. Accordingly, the storage amount of the refrigerant liquid LQ is reduced, and thus a storage amount of the expensive fluorine-based refrigerant can be reduced. As a result, for example, the cost is reduced as compared with a case where only the refrigerant liquid LQ is used for cooling the electric circuit 50. Cooling is performed using the insulating oil OL in a liquid state without vaporizing the insulating oil OL.

The vaporized refrigerant liquid LQ moves from the lower space to the upper space in the tank 10 through the through holes 52a. The insulating oil OL also receives heat from the vaporized refrigerant liquid LQ. As a result, a part of the vaporized refrigerant liquid LQ is liquefied by heat radiation to the insulating oil OL. The insulating oil OL having received heat and the vaporized refrigerant liquid LQ are cooled by the coolant near a ceiling in the tank 10. As a result, the vaporized refrigerant liquid LQ is also liquefied. The liquefied refrigerant liquid LQ has a larger specific gravity than the insulating oil OL. Therefore, the liquefied refrigerant liquid LQ sinks in the insulating oil OL and returns from the upper space to the lower space in the tank 10 via the through holes 52a.

The insulating oil OL is stirred by the vaporized refrigerant liquid LQ. As a result, the forced convection is generated in the insulating oil OL without adding a device for forced convection such as a pump, and the cooling efficiency of the insulating oil OL having received heat is increased compared to the case of natural convection. In the tank 10, a circulating flow of the refrigerant liquid LQ is generated between the lower space and the upper space due to vaporization and liquefaction of the refrigerant liquid LQ. At this time, the vaporized refrigerant liquid LQ passes through some of the plurality of through holes 52a, and the liquefied coolant liquid LQ passes through the remaining through holes 52a. As a result, the forced convection flows as indicated by an arrow, for example.

The air chamber AR communicates with the inside of the tank 10 via the communication passage C. Therefore, an increase in the internal pressure of the tank 10 due to vaporization of the refrigerant liquid LQ is further prevented by the sub-tank 20. As a result, sealing by the seal member 13 is facilitated. Since an increase in a boiling point of the refrigerant liquid LQ is prevented, it is also possible to prevent the vaporization heat cooling from being difficult to perform. Further, the air chamber AR provided as described above is a separate chamber from the inside of the tank 10. Therefore, a structure in which the refrigerant liquid LQ is less likely to enter the air chamber AR can be simultaneously obtained. The refrigerant liquid LQ is prevented from entering the sub-tank 20 in a vaporized state by the shielding plate 14, and is prevented from entering the sub-tank 20 in a liquefied state by the shielding plate 15.

The breather cap 23 maintains the inside of the tank 10 at atmospheric pressure. Therefore, the fluctuation of the boiling point of the refrigerant liquid LQ is prevented, and the rise in the boiling point due to the increase in the internal pressure of the tank 10 is avoided. Therefore, if the temperature does not become higher, a situation in which vaporization heat cooling is not performed is avoided. In addition, since the inside of the tank 10 is maintained at the atmospheric pressure, sealing by the seal member 13 is facilitated as compared with a case where the pressure is higher. The refrigerant liquid LQ, which is a fluorine-based refrigerant, has lower viscosity and surface tension than the insulating oil OL, and easily passes through the seal member 13. Therefore, even when the insulating oil OL is subjected to leakage prevention, sealing by the seal member 13 is facilitated.

Next, main functions and effects of the present embodiment will be described.
(1) The cooling device 100 cools the electric circuit 50, which is a power semiconductor device. The cooling device 100 includes the tank 10 that accommodates the electric circuit 50, the insulating oil OL, and the refrigerant liquid LQ having a boiling point temperature lower than a boiling point temperature of the insulating oil OL and a specific gravity larger than a specific gravity of the insulating oil OL. The insulating oil OL and the refrigerant liquid LQ are stored in the tank 10 in a mixed state to cool the electric circuit 50.
   According to such a configuration, the insulating oil OL and the refrigerant liquid LQ stored in the tank 10 in the mixed state are present at different positions in the height direction due to a difference in specific gravity. As a result, the refrigerant liquid LQ having a large specific gravity is positioned below the insulating oil OL. Therefore, by performing vaporization heat cooling with the refrigerant liquid LQ without particularly adding a device for forced convection, the insulating oil OL above the vaporized refrigerant liquid LQ can be stirred, and thus the insulating oil OL having received heat can be forced convection. Accordingly, it is possible to achieve both simplification of the device and high cooling efficiency of the insulating oil OL having received heat.
(2) In the present embodiment, the refrigerant liquid LQ is a fluorine-based refrigerant. According to such a configuration, it is possible to cause the refrigerant liquid LQ having a boiling point temperature lower than a boiling point temperature of the insulating oil OL and a specific gravity larger than a specific gravity of the insulating oil OL to perform vaporization heat cooling.
(3) The cooling device 100 further includes the sub-tank 20 having the air chamber AR, and the communication passage C that allows the air chamber AR to communicate with the inside of the tank 10. According to such a configuration, the increase in the internal pressure of the tank 10 due to vaporization of the refrigerant liquid LQ can be prevented. Accordingly, the sealing by the seal member 13 is facilitated. Since the increase in the boiling point of the refrigerant liquid LQ is prevented, it is also possible to prevent the vaporization heat cooling from being difficult to perform. Further, since the air chamber AR is provided as a separate chamber from the inside of the tank 10, it is possible to obtain a structure in which the refrigerant liquid LQ hardly enters the air chamber AR while obtaining the functions and effects.
(4) The sub-tank 20 includes the breather cap 23 that allows the air chamber AR to communicate with the atmosphere outside the sub-tank 20. According to such a configuration, the inside of the tank 10 is maintained at the atmospheric pressure, and thus the fluctuation of the boiling point of the refrigerant liquid LQ is prevented. Therefore, it is possible to avoid a situation in which the boiling point rises more as the internal pressure of the tank 10 increases, and the vaporization heat cooling is not performed unless the temperature becomes higher. Further, since the inside of the tank 10 is maintained at the atmospheric pressure, the sealing by the seal member 13 becomes easier.
(5) The electric circuit 50 includes the semiconductor devices 55a and the capacitor 55d. The semiconductor device 55a, which is an electronic component having a relatively higher heat generation density, among the semiconductor devices 55a and the capacitor 55d is accommodated in the tank 10 while being immersed in the refrigerant liquid LQ. According to such a configuration, the electric circuit 50 can be effectively cooled by vaporization heat cooling the semiconductor device 55a having a relatively higher heat generation density by the refrigerant liquid LQ. Further, since the capacitor 55d may be cooled by the insulating oil OL, it is possible to appropriately cool a plurality of electronic components according to the heat generation density, and it is also possible to reduce the cost by reducing the storage amount of the refrigerant liquid LQ.
(6) The tank 10 includes the first housing portion 11, the second housing portion 12, and the seal member 13 that seals between the first housing portion 11 and the second housing portion 12 coupled to each other. The seal member 13 is provided within a range in the height direction in which the insulating oil OL is stored in accordance with the specific gravit. According to such a configuration, since the insulating oil OL is subjected to leakage prevention, sealing by the seal member 13 is facilitated.

The electric circuit 50 may be accommodated in the cooling device 100 as described below.

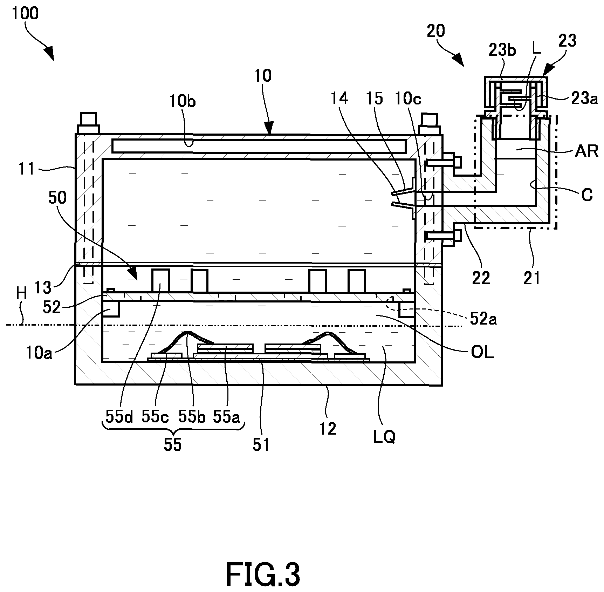

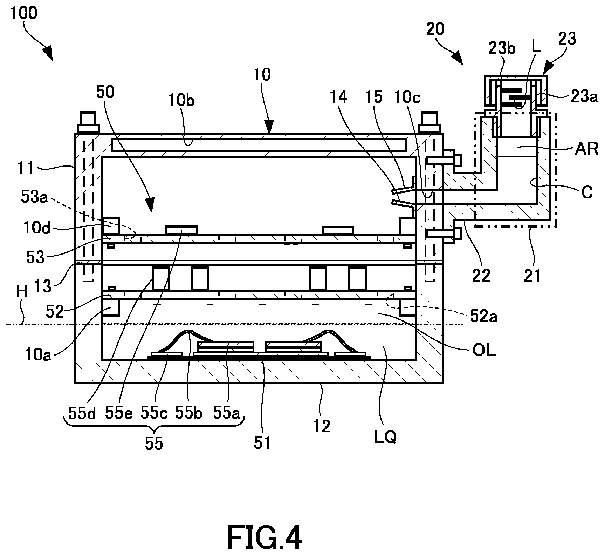

FIGS. 3 and 4 are diagrams showing modifications of the electric circuit 50 and the cooling device 100. In the example shown in FIG. 3, the first substrate 51 is provided on a bottom surface in the tank 10, and is electrically connected to the second substrate 52 via a connector or wiring. The plurality of through holes 52a may be provided at positions overlapping the first substrate 51 in the vertical direction. The second substrate 52 is provided above the case of the present embodiment shown in FIGS. 1 and 2 together with the boss 10a, but the liquid surface height H of the refrigerant liquid LQ is the same as that in the present embodiment. As a result, also in this example, the semiconductor device 55a is positioned below the liquid surface height H, and the capacitor 55d is positioned above the liquid surface height H. Accordingly, the semiconductor device 55a is accommodated in a lower portion of the tank 10 while being immersed in the refrigerant liquid LQ, and the capacitor 55d is accommodated while being immersed in the insulating oil OL. Even in the case of such a configuration, the insulating oil OL above the vaporized refrigerant liquid LQ can be stirred, and the insulating oil OL having received heat can be forced convection. Therefore, it is possible to achieve both simplification of the device and high cooling efficiency of the insulating oil OL having received heat.

In the example shown in FIG. 4, as compared with the example shown in FIG. 3, the electric circuit 50 further includes a third substrate 53, and the tank 10 further includes a boss 10d. The boss 10d is provided on the first housing portion 11, and the third substrate 53 is fixed to the boss 10d from an opening side of the first housing portion 11. Accordingly, the third substrate 53 is provided above the second substrate 52. The third substrate 53 is provided below the through hole 10c. Diodes 55e are mounted on the third substrate 53. A plurality of diodes 55e are provided and serve as components of the circuit portion 55. Accordingly, in this example, the circuit portion 55 is mounted on the first substrate 51, the second substrate 52, and the third substrate 53, and the third substrate 53 is electrically connected to the first substrate 51 and the second substrate 52 via a connector or wiring. Similarly to the capacitor 55d, each of the diodes 55e has a lower heat generation density than the semiconductor device 55a, and is accommodated while being immersed in the insulating oil OL. That is, in this example, the diode 55e is an example of an electronic component other than the semiconductor device 55a of a plurality of electronic components included in the electric circuit 50 together with the capacitor 55d. Even in the case of such a configuration, the insulating oil OL above the vaporized refrigerant liquid LQ can be stirred, and the insulating oil OL having received heat can be forced convection. Therefore, it is possible to achieve both simplification of the device and high cooling efficiency of the insulating oil OL having received heat.

Although the embodiments of the present invention have been described above, the above embodiments are merely a part of application examples of the present invention, and are not intended to limit the technical scope of the present invention to the specific configurations of the above embodiments.

For example, the sub-tank 20 may include an air breather mechanism integrally formed with the tank portion 21 instead of the breather cap 23.

### DESCRIPTION OF REFERENCE SIGNS

- 10: tank
- 10c: through hole
- 11: first housing portion
- 12: second housing portion
- 13: seal member
- 20: sub-tank
- 21: tank portion
- 22: connection portion
- 23: breather cap (air breather mechanism)
- 11: case
- 12: electric circuit
- 50: electric circuit 50
- 55: circuit portion
- 55a: semiconductor device
- 55d: capacitor
- 100: cooling device
- AR: air chamber
- C: communication passage
- LQ: refrigerant liquid (fluorine-based refrigerant)
- OL: insulating oil

## Claims

1. A cooling device for cooling a power semiconductor device, the cooling device comprising:
a tank configured to accommodate the power semiconductor device; insulating oil; and
a refrigerant liquid having a boiling point temperature lower than a boiling point temperature of the insulating oil and a specific gravity larger than a specific gravity of the insulating oil,
wherein
the insulating oil and the refrigerant liquid are stored in the tank in a mixed state to cool the power semiconductor device.

2. The cooling device according to claim 1, wherein
the refrigerant liquid is a fluorine-based refrigerant.

3. The cooling device according to claim 1, further comprising:
a sub-tank having an air chamber; and
a communication passage configured to allow the air chamber to communicate with an inside of the tank.

4. The cooling device according to claim 3, wherein
the sub-tank includes an air breather mechanism that allows the air chamber to communicate with an atmosphere outside the sub-tank.

5. The cooling device according to any one of claims 1 to 4, wherein
the power semiconductor device includes a plurality of electronic components having different heat generation densities, and
the electronic component having a relatively higher heat generation density among the plurality of electronic components is accommodated in a lower portion of the tank while being immersed in the refrigerant liquid.

6. The cooling device according to any one of claims 1 to 4, wherein
the tank includes a first housing portion, a second housing portion, and a seal member that seals between the first housing portion and the second housing portion coupled to each other, and
the seal member is provided within a range in a height direction in which the insulating oil is stored in accordance with the specific gravity.
